# EUROPEAN PATENT SPECIFICATION

(11) **EP 1 444 800 B1**
(45) Date of publication and mention of the grant of the patent: **27.12.2006**
(21) Application number: 02772615.7
(22) Date of filing: 06.11.2002
(51) Int. Cl.: H04H 1/00, H03D 7/14

(54) **DIGITAL AUDIO BROADCAST DEVICES**
DIGITALE AUDIO RUNDFUNK (DAB) VORRICHTUNGEN
DISPOSITIFS DE RADIODIFFUSION NUMERIQUE (RAN)

(30) Priority: 06.11.2001 GB 0126623
(43) Date of publication of application: 11.08.2004
(60) Divisional application: 06004608.3
(73) Proprietor: The Technology Partnership Plc, Melbourn, Royston, Hertfordshire SG8 6EE (GB)
(72) Inventor: DAVIES, Richard Lewis, Gamlingay, Sandy SG19 3NE (GB); LOUKINE, Mikhail Yuri, Melbourn, Royston, Hertfordshire SG8 6NG (GB); ORRELL, Martin, Bromham, Bedfordshire MK43 8JB (GB)
(74) Representative: Finnie, Peter John
(86) International application number: PCT/GB2002/005008
(87) International publication number: WO 2003/041312

(56) References cited:
- EP-A- 0 336 191
- EP-A- 0 689 308
- EP-A- 0 883 238
- US-A- 5 339 463
- GOLDFARB M ET AL: "A Si BJT downconverter/AGC IC for DAB" RADIO FREQUENCY INTEGRATED CIRCUITS (RFIC) SYMPOSIUM, 1998 IEEE BALTIMORE, MD, USA 7-9 JUNE 1998, NEW YORK, NY, USA,IEEE, US, 7 June 1998 (1998-06-07), pages 305-308, XP010285166 ISBN: 0-7803-4439-1
- TITUS W ET AL: "A Si BJT RF dual band receiver IC for DAB" MICROWAVE SYMPOSIUM DIGEST, 1998 IEEE MTT-S INTERNATIONAL BALTIMORE, MD, USA 7-12 JUNE 1998, NEW YORK, NY, USA,IEEE, US, 7 June 1998 (1998-06-07), pages 345-348, XP010290015 ISBN: 0-7803-4471-5
- BOLLE M ET AL: "The receiver engine chip-set for digital audio broadcasting" SIGNALS, SYSTEMS, AND ELECTRONICS, 1998. ISSSE 98. 1998 URSI INTERNATIONAL SYMPOSIUM ON PISA, ITALY 29 SEPT.-2 OCT. 1998, NEW YORK, NY, USA,IEEE, US, 29 September 1998 (1998-09-29), pages 338-342, XP010316821 ISBN: 0-7803-4900-8
- TITUS W ET AL: "A Si BJT RF dual band receiver IC for DAB" RADIO FREQUENCY INTEGRATED CIRCUITS (RFIC) SYMPOSIUM, 1998 IEEE BALTIMORE, MD, USA 7-9 JUNE 1998, NEW YORK, NY, USA,IEEE, US, 7 June 1998 (1998-06-07), pages 297-300, XP010285130 ISBN: 0-7803-4439-1

## Description

### Field of the Invention

The present invention relates to digital audio broadcast (DAB) technology and in particular to a low cost, low power DAB terminal.

### Background to the Invention

Digital audio broadcast (DAB) to the Eureka 147 Standard is a radio broadcast system designed to deliver high quality digital audio information together with associated programme data. It is also capable of delivering high rate data services. Uptake of DAB in the audio market has however been slow, largely due to the high cost of receivers relative to the perceived benefit over frequency modulation (FM) radio.

However, significant interest has emerged recently from service providers wishing to offer data services such as news, sport and other multi-media information via a broadcast system. The interest derives from the substantially lower cost of broadcasting such information to a large number of users as compared with point to multi-point delivery via mobile networks such as GSM, GPRS and 3G.

Further opportunities are perceived if a return data channel could be used with DAB. Higher value services, such as used in e-commerce, can be delivered with the return channel used for service selection and purchase transactions. The return channel could be provided by the public switched telephone network (PSTN) or for mobile users using Global System for Mobile Communications (GSM), General Packet Radio Service (GPRS) or Bluetooth. Whilst the potential benefits of DAB as described above are recognised, no-one has yet solved the problem of providing a low-cost mobile DAB module (i.e. battery powered) because the cost and size of first generation components and their inherent power consumption is too high. There is therefore a need for an improved design for DAB modules which is lower cost, has lower power consumption and is portable.

The present invention relates to a small, low cost, low power original equipment manufacturer (OEM) module for DAB radio reception which can be used for audio and data services, one way or with a return channel. Such a product could form an essential part of a range of hand-held, and fixed products in a number of industry sectors and for a number of customers. For example, using audio only data, such a module would be useful for portable radios and fixed radios such as hi-fis or car radios. Systems capable of handling both audio and data services would be suitable for mobile telephones, PDAs, portable PCs, PC cards and fixed PCs.

The present invention includes a number of features which minimise the system component count, and therefore size and cost, and incorporates certain power saving measures. The present invention will be described with specific reference to the Hitachi chip Serial No. HD155080TF, the leading DAB receiver chip on the market

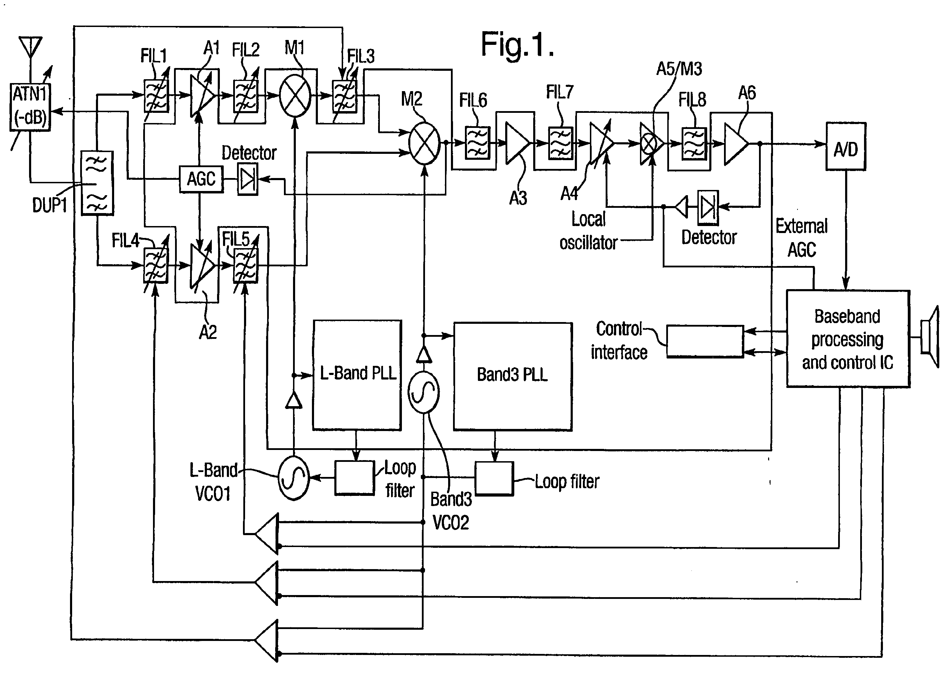

Figure 1 shows a typical previous implementation of the HD155080TF chip to produce a DAB module. The antenna receives an input radio frequency signal which is divided by duplexer DUP1 into separate L band and VHF parts. The receiver can be programmed to receive either L band signals or band III VHF signals.

The L band signal takes the upper path as shown in Figure 1 and is band pass filtered by the input filter, Fil 1 and subsequently amplified by the low noise amplifier (LNA) A1. The signal is then band pass filtered by filter Fil 2 before being mixed by mixer M1 with a fixed frequency local oscillator signal, formed by VCO1 and an associated synthesiser, to a band III VHF frequency.

On the other hand the band III signal is filtered by a voltage controlled, tracking band pass filter, Fil 4, before being amplified by the LNA, A2. The purpose of the filtering, both at the L band and at the band III frequencies, is to protect the receiver from large interfering signals, particularly at the receiver's image frequencies.

The Coded Orthogonal Frequency Division Multiplex (COFDM) modulation scheme used in DAB is very susceptible to distortion. In order to prevent this distortion when receiving large amplitude signals, whilst still having a sensitive receiver capable of receiving small signals, it is necessary to introduce an automatic gain control system (AGC).

Automatic gain control system designs have typically used a PIN diode attenuator (ATN1) before the input duplexer in conjunction with gain control of A1 and A2 to control the level of the signal reaching mixer M2, from both the wanted transmission and other unwanted interfering signals. The attenuator used, consisting of a dual PIN diode, 5 capacitors and 7 resistors, typically costs around 20p.

The next stage of the processing of the received signal of the DAB system shown in Figure 1 is band pass filtering. The L band signal, now mixed down to a band III frequency is band pass filtered by filter Fil 3. The band III signal is band pass filtered by filter Fil5. After the filtering both signals are mixed down to the 38.912 MHz If frequency in mixer M2.

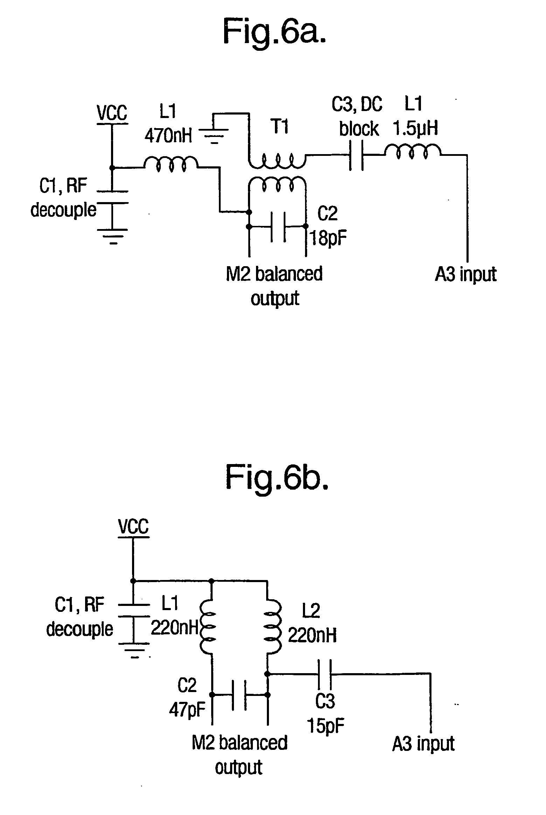

After the now combined L band/band III signal is mixed down to the 38.912MHz frequency the signal is filtered by filter Fil 6. Previous designs based around the HG155080TF chip use a conventional wire wound, wide band transformer plus two wire wound inductors and three capacitors (approximate cost 60p) to feed power to the balanced mixer contained within the chip, plus provide filtering of the local oscillator and matching to the next amplifier stage A3. This is shown in Figure 6a.

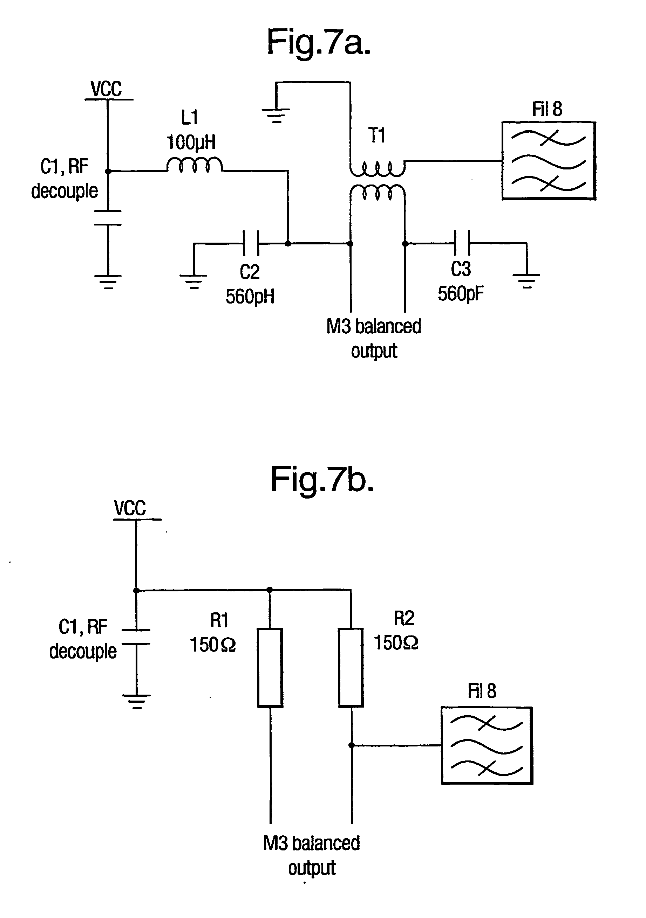

The signal is then amplified by A3 and band pass filtered by a SAW filter, Fil 7. After filtering, the signal is amplified by the main AGC amplifier A4. After amplification, the signal is mixed to the final IF frequency, of typically 2.048 MHz, by A5/M3. A5/M3 has a balanced output. Previous designs used a conventional wire wound transformer plus a large 100 µH RF choke and several capacitors to try and provide power to the mixer and convert the balanced signal to a single ended version. The cost for these parts is estimated to be around 75p. They are shown in Figure 7a. Finally, the signal is passed through filter Fil 8, amplifier A6 and an analogue/digital converter before reaching the baseband control.

### Summary of the Invention

According to the present invention, there is provided a DAB receiver circuit comprising a variable tracking filter (Fil 4) for filtering input signals wherein the pass band of the tracking filter is offset to increase attenuation when the amplitude of the input signal rises above a first threshold and is returned to its original position to decrease attenuation when the amplitude of the input signal falls below a second threshold so as to provide automatic signal attenuation.

The attenuator is eliminated by using the tracking filter as an attenuator for band III reception. When receiving low level signals the filter is adjusted so that it passes the wanted signal with little attenuation. When the receiver detects that is receiving a large amplitude signal it adjusts the filter so that it attenuates the large input signal by setting the pass band of the filter to a different centre frequency than the frequency the receiver is tuned to. When receiving high level signals, the pass band of the filter is offset to a frequency as far away from the image frequency as possible, thereby ensuring that the relative attenuation of the image frequency compared with the wanted frequency is maintained.

### Brief description of the Drawings

Examples of the present invention will now be described in detail with reference to the accompanying drawings, in which:-
Figure 1 is a schematic representation of a typical previous DAB module;
Figure 2 is a schematic representation of a DAB module according to the present invention;
Figure 3A shows the frequency response for fitter 4 in Figure 2 at tow level signal reception;
Figure 3B shows filter 4's frequency response at high level signal reception;
Figure 4a shows in detail combined filter Fil 3/5 of Figure 2;
Figure 4b shows in detail fitter Fil 3 of Figure 1;
Figure 4c shows in detail fitter Fil 5 of Figure 1;
Figure 5a is a flow diagram showing a dither technique used to centre the tracking filters according to the present invention;
Figure 5b is a flowchart for the baseband processing decisions used to control the tracking filters;
Figure 6a is a schematic representation of Fil 6 of Figure 1;
Figure 6b is a schematic representation of the improved Fil 6 of Figure 2;
Figure 7a shows the interconnect to M3 in Figure 1; and,
Figure 7b shows the cost reduced interconnect to M3 in Figure 2.

### Detailed Description

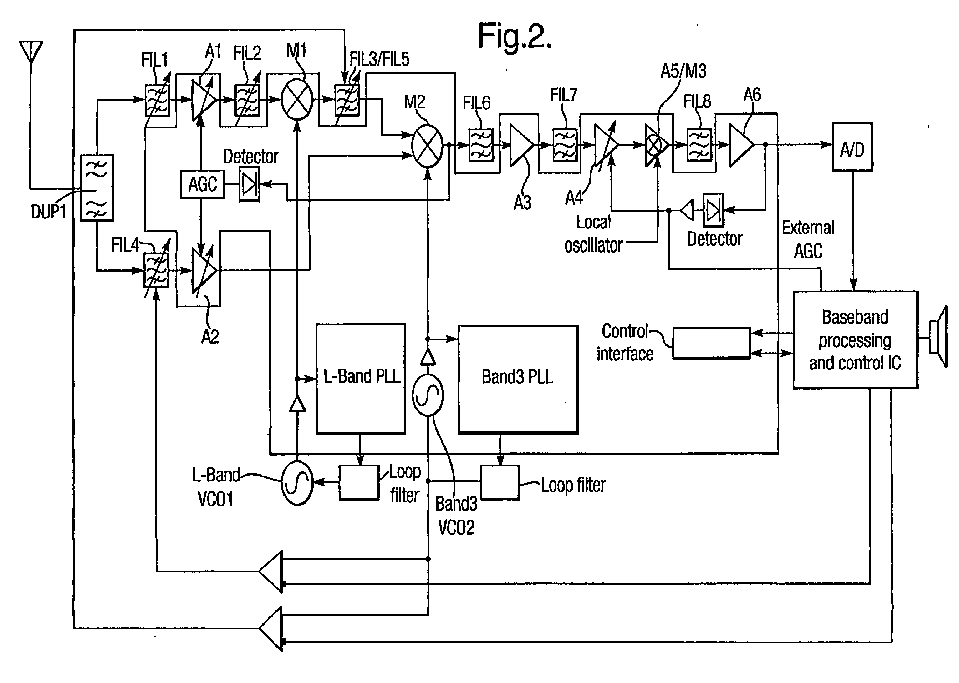

Figure 2 is a schematic representation of an HD155080TF chip attached to which are various components in accordance with the present invention, to provide a DAB receiver module. Some of the subsequent Figures ascribe particular values to these components, however, the person of ordinary skill in the art will understand these values to be by way of example only. The invention is not limited to the specific values indicated.

An incoming signal is received by the antenna and is routed through DUP1 either to Fil 1 if it is an L band signal or to Fil 4 if it is a band III signal.

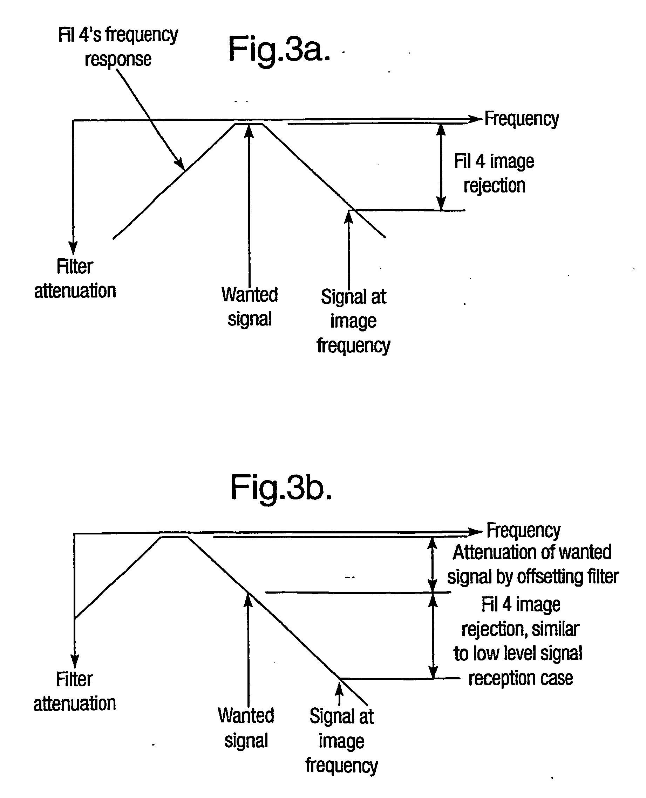

Fil 4 is a tunable filter and its frequency response is adjusted to provide an automatic attenuation system. This is shown in more detail in Figures 3A and 3B. When the incoming signal has a low amplitude Fil 4 is adjusted so that it passes the wanted signal with little attenuation, as shown in Figure 3A. However, when the receiver detects the input signal has a large amplitude Fil 4 is adjusted so that the pass band is at a different centre frequency to the wanted signal. As shown in Figure 3B this means that the wanted signal is attenuated to a much greater extent In this manner the relative attenuation of the image frequency compared to the wanted frequency can be maintained. In a simple embodiment of the invention, if the input signal amplitude falls below a first threshold level the filter is centred as in Figure 3a, and if it rises above a second, higher threshold level the fitter is offset by a fixed amount as in Figure 3b, the two threshold levels being set by the amplitude measuring circuit to provide hysteresis. The invention provides automatic attenuation for input signals large enough to cause overloading and distortion in the system, saving costs by eliminating ATN 1 in Figure 1.

Referring again to Figure 2, the L band signal is band pass filtered by the input filter, Fil 1, amplified by the low noise amplifier (LNA) A1, and then band pass filtered by Fil 2. The L band signal is then mixed by mixer M1 with the fixed frequency local oscillator formed by VCO 1 and associated synthesiser, to a band III VHF frequency.

The band III signal is tittered by a voltage controlled tracking band pass filter, Fil 4 as described above, before being amplified by the LNA, A2. The purpose of filtering both at L band and band III frequencies is to protect the receiver from large interfering signals, particular at the receivers image frequencies.

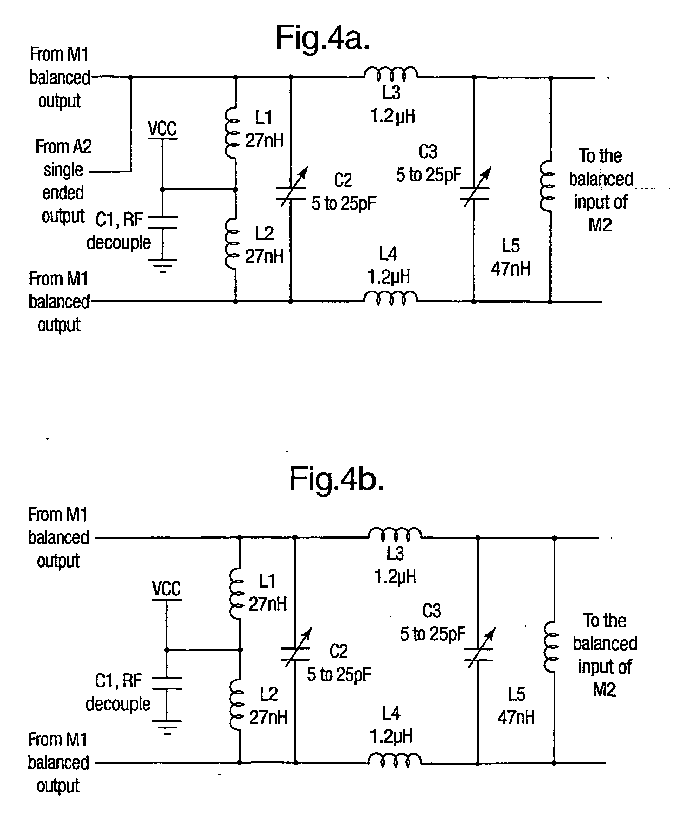

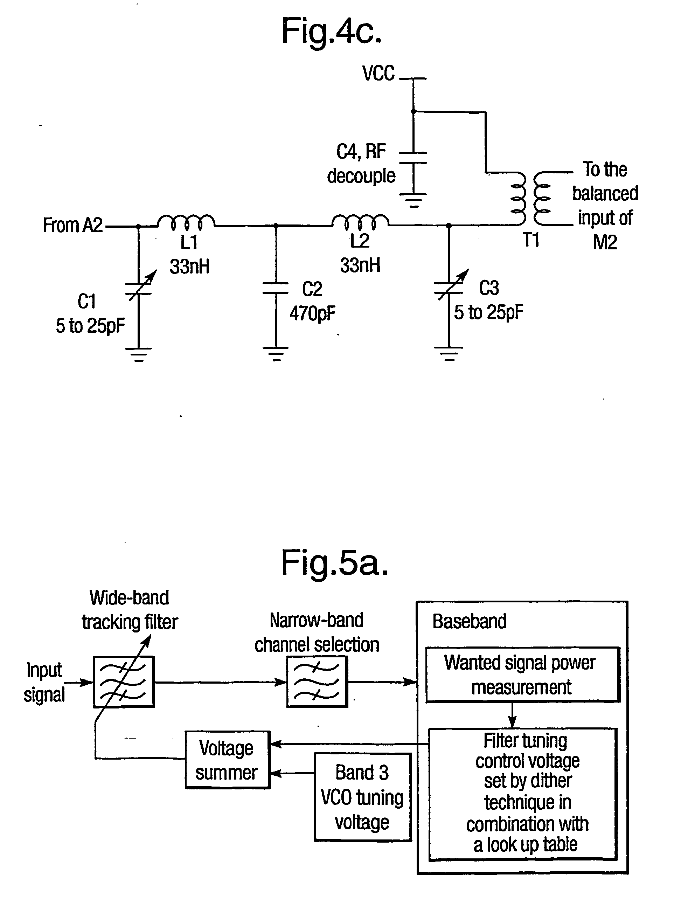

The L band signal now mixed to a band III frequency is then filtered by Fil 3/Fil 5. The structure of this combined filter, Fil 3/Fil 5 is shown in Figure 4a. The filter is an inductively coupled dual resonator filter. The first resonator is formed by L1, L2 and C2. The second resonator is formed by L5 and C3: Both C2 and C3 are implemented as varactor diodes allowing the resonators to be tuned to any frequency within the received frequency band. In operation both resonators are tuned to the same frequency. The resonators are high impedance at resonance and do not attenuate the signal. At other frequencies the resonators are low impedance and attenuate the signal. To simplify Figures 4a; 4b and 4c, details of the parts required to DC isolate and tune the varactor diodes are not shown. These details are equivalent for Figures 4a and 4b.

DC power is supplied to M1 via inductors L1 and L2, and to A2 via L1. At any one time A2 or M1 is switched off. When either M1 or A2 is switched off the respective output is high impedance. The filter has a balanced input for the signal from M1. The single ended signal from A2, at the same frequency as the frequency of the first resonator formed by L1, L2 and C2, is converted by the first resonator to a balanced signal. The filter has a balanced output for connection to M2.

The structure of the prior filters shown in Figure 1, Fil 3 and Fil 5 are shown in Figure 4b and 4c respectively. Fil 3 has a similar structure to Fil3/Fil5 and operates in substantially the same way. Fil 3 is essentially formed of two resonators which have high impedance at resonance and so do not attenuate the signal.

Fil 5 has a different structure. C1, C2, C3, L1 and L2 form a low pass filter. The values of C1 and C3 are variable and they are implemented as varactor diodes. This allows the cut-off frequency of the filter to be adjusted. Transformer T1 DC isolates M2 from A2, converts the single ended signal to a balanced signal and allows DC power to be fed to A2.

It can easily be seen from a comparison of Fil3/Fil5 with Fil3 and Fil5 that the combined Fil3/Fil5 eliminates all of the components of Fil 5 from the overall design. This gives significant cost and power savings.

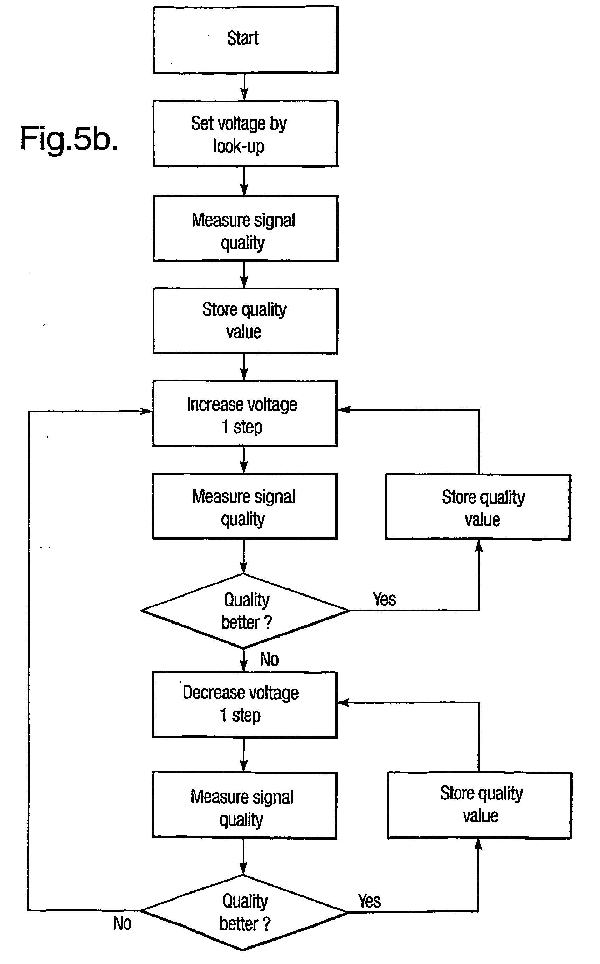

The tracking filters, Fil 4 and Fil 3/5, are tuned using a dither technique. As shown in Figure 2 the tuning voltage of these filters is a combination of a band III VCO tuning voltage and a voltage from the baseband. The combined voltage is initially set to approximately the correct value determined by the voltage used to tune the band III synthesiser and a look-up table in the base band. Whilst operating, the filters' tuning voltage is continually adjusted to increase and decrease it in small steps. The baseband processor monitors the quality of the wanted signal reaching the base band to determine if each small adjustment improves or degrades the signal quality reaching it compared with a previous value. If the adjustment improves the signal quality reaching the baseband, then the baseband processor knows that the filter is then more accurately centred on the desired signal. The baseband processor then uses this new voltage as the basis for subsequently adjusting the tuning voltage up or down. This technique is illustrated by Figure 5a and allows wider tolerance for the tracking filter components and provides more reliable performance by tracking any changes of filter performance with temperature, time etc.. The signal quality determination can be made on the basis of signal amplitude, power, bit error rate or a combination of these measures. Figure 5b shows a flow diagram of a possible decision algorithm implemented by the baseband processor to control the tracking filters, however other algorithms are possible. The voltage is initially set by a look-up table and signal quality measured and stored. The voltage is then increased by a small step and the signal quality measured and compared with the stored signal quality. If signal quality is improved the new signal quality is stored and the process repeated by increasing the voltage again. If the signal quality is not improved the voltage is decreased by a small step and the new signal quality measured and compared with the stored signal quality. if signal quality is improved the new signal quality is stored and the process repeated by decreasing the voltage again. If the signal quality is not improved the voltage is increased by a small step and process repeated again.

The combined L band, band III signal from Fil 3/5 is mixed down to the 38.912 MHz IF frequency by mixer M2. It is then passed through filter Fil 6. The structure of Fil 6 is shown in more detail in Figure 6b. The typical previous implementation is shown in Figure 6a.

Referring to Filter 6 as shown in Figure 6a, the primary side of transformer T1 is tuned by C2 to the output frequency, 38.9MHz, of M2. L1 acts as an RF choke blocking the path to VCC or ground to RF signals. L2 couples and impedance matches the secondary side of the transformer to the A3 input C3 acts as a DC block.

Filter 6 shown in Figure 6b consists of an narrow band transformer consisting of two multi-layer inductors and a capacitor and provides filtering and impedance matching to A3. Inductors L1 and L2 in combination with a capacitor C2 resonate at 38.9 MHz allowing a potential difference to be developed at 38.9 MHz across the capacitor C2. Energy from both outputs of the mixer is coupled into A3 through capacitor C3. At other frequencies the circuit is not resonant and therefore the circuit acts as a 38.9 MHz band pass filter. As the degree of filtering is not crucial, lower Q inductors can be used hence saving cost

The signal is then amplified by amplifier A3, and pass band filtered by a SAW filter Fil 7. After filtering, the signal is amplified by the main AGC amplifier A4. After this amplification, the signal is mixed to the final RF frequency of typically 2.048 MHz by M3. The signal is then filtered by filter 8. The complicated and expensive interconnect that has been used typically in the past is shown in Figure 7a. The primary side of transformer T1 is tuned by C2 and C3 to the output frequency, 2.048MHz, of M3. Power is fed to both outputs of M3 via the transformer. L1 acts as an RF choke blocking the path to VCC or ground to RF signals. L1 needs to be a large value, typically 1 00µH, and therefore a large size to be effective at 2.048MHz- Signals from M3 are coupled to Fil 8 by the transformer which provides DC isolation between the filter and M3.

As the input signal to this stage is band pass filtered and due to AGC amplifier A4, of fixed amplitude, the dynamic range and gain of this stage is not critical to the performance of the design. The interconnect to M3 according to the present invention is therefore very simple and uses two resistors in parallel to provide a load and feed power to the mixer. This is shown in Figure 7b and is clearly less complicated and less expensive than the prior interconnect.

The present invention provides a low cost, low power stand-alone DAB module. No-one has yet provided a stand-alone DAB module which can be battery powered and the present invention goes some way towards achieving this aim.

## Claims

1. A DAB receiver circuit comprising:
a variable tracking filter (Fil 4) for filtering input signals wherein the pass band of the tracking filter is offset to increase attenuation when the amplitude of the input signal rises above a first threshold and is returned to its original position to decrease attenuation when the amplitude of the input signal falls below a second threshold so as to provide automatic signal attenuation.

## Patentansprüche

1. Digitale Audio-Rundfunk(DAR)-Empfängerschaltung, umfassend:
ein veränderliches Mitlauffilter (Fil 4) zum Filtern von Eingangssignalen, wobei der Durchlassbereich des Mitlauffilters zum Vergrößern einer Dämpfung verschoben wird, wenn die Amplitude des Eingangssignals über eine erste Schwelle steigt, und zum Verringern einer Dämpfung auf seine Ausgangsposition zurückgesetzt wird, wenn die Amplitude des Eingangssignals unter eine zweite Schwelle fällt, um eine automatische Signaldämpfung bereitzustellen.

## Revendications

1. Circuit de récepteur RAN comprenant :
Un filtre de poursuite variable (Fil 4) pour filtrer les signaux d'entrée, dans lequel la bande passante du filtre de poursuite est décalée pour augmenter l'atténuation lorsque l'amplitude du signal d'entrée s'élève au-dessus d'un permier seuil et est renvoyée à sa position d'origine pour diminuer l'atténuation lorsque l'amplitude du signal d'entrée chute au-dessous d'un second seuil de façon à fournir une atténuation de signal automatique.
